(19) Europäisches Patentamt / European Patent Office / Office européen des brevets

(11) **EP 4 012 437 B1**

(12) **EUROPÄISCHE PATENTSCHRIFT**

(45) Veröffentlichungstag und Bekanntmachung des Hinweises auf die Patenterteilung:
**11.02.2026   Patentblatt 2026/07**

(21) Anmeldenummer: **20213423.5**

(22) Anmeldetag: **11.12.2020**

(51) Internationale Patentklassifikation (IPC):
**G01R 33/565** (2006.01)     **G01R 33/48** (2006.01)
**G01R 33/56** (2006.01)

(52) Gemeinsame Patentklassifikation (CPC):
**G01R 33/565; G01R 33/4818; G01R 33/5608**

(54) **MAGNETRESONANZTOMOGRAPHIE MIT DUALER AUFNAHME ZUR STÖRUNGSREDUKTION**

MAGNETIC RESONANCE TOMOGRAPHY WITH DUAL ACQUISITION FOR INTERFERENCE REDUCTION

TOMOGRAPHIE PAR RÉSONANCE MAGNÉTIQUE À DOUBLE ENREGISTREMENT DESTINÉ À LA RÉDUCTION DES INTERFÉRENCES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(43) Veröffentlichungstag der Anmeldung:
**15.06.2022   Patentblatt 2022/24**

(73) Patentinhaber: **Siemens Healthineers AG**
**91301 Forchheim (DE)**

(72) Erfinder:
• **Biber, Stephan**
**91056 Erlangen (DE)**
• **Grodzki, David**
**91058 Erlangen (DE)**
• **Kannengießer, Stephan**
**42113 Wuppertal (DE)**
• **Schneider, Rainer**
**91054 Erlangen (DE)**

(74) Vertreter: **Siemens Healthineers**
**Patent Attorneys**
**Postfach 22 16 34**
**80506 München (DE)**

(56) Entgegenhaltungen:
EP-A1- 3 470 868          EP-A1- 3 723 037
US-A1- 2017 108 569       US-A1- 2018 143 272

**Beschreibung**

Die vorliegende Erfindung betrifft ein Verfahren zum Betreiben eines Magnetresonanztomographiesystems, ein Magnetresonanztomographiesystem sowie ein Computerprodukt.

Systeme zur Magnetresonanztomographie, MRT, sind bildgebende Vorrichtungen, die zur Abbildung eines Untersuchungsobjekts Kernspins des Untersuchungsobjekts mit einem starken äußeren Magnetfeld ausrichten und durch ein magnetisches Wechselfeld zur Präzession um die entsprechende Ausrichtung anregen. Die Präzession beziehungsweise die Rückkehr der Spins aus diesem angeregten Zustand in einen Zustand mit geringerer Energie wiederum erzeugt als Antwort ein magnetisches Wechselfeld, das über Empfangsantennen detektiert werden kann.

Mithilfe von magnetischen Gradientenfeldern kann den Signalen eine Ortscodierung aufgeprägt werden, die nachfolgend eine Zuordnung von dem empfangenen Signal zu einem Volumenelement des Untersuchungsobjekts ermöglicht. Das empfangene Signal kann dann ausgewertet werden, beispielsweise um eine dreidimensionale bildgebende Darstellung des Untersuchungsobjekts bereitzustellen. Als Empfangsantennen können beispielsweise lokale Empfangsantennen, sogenannte Lokalspulen, verwendet werden, die zur Erzielung eines besseren Signal-Rausch-Verhältnisses, SNR, unmittelbar an dem Untersuchungsobjekt angeordnet werden können. Die Empfangsantennen können aber auch in der Umgebung des Untersuchungsobjekts angeordnet sein oder beispielsweise in einer Patientenliege verbaut sein.

Die für die Bildgebung zu empfangenden Magnetresonanz-, MR-, Signale sind extrem schwach, sodass bei bekannten MRT-Systemen eine Abschirmung externer Störsignale erforderlich ist, um ein ausreichendes SNR zu erreichen. Dazu werden insbesondere aufwendige Schirmkabinen installiert, um die störenden Immissionen zu reduzieren. Dies führt zu erheblichen Kosten und baulichen Einschränkungen aufgrund des entsprechenden Platzbedarfs.

Im Dokument WO 2019/068687 A2 werden ein Magnetresonanztomograph mit aktiver Störunterdrückung und ein entsprechendes Verfahren beschrieben. Dabei ist eine erste Empfangsantenne zum Empfang eines Magnetresonanzsignals aus einem Patienten vorgesehen und eine zweite Empfangsantenne zum Empfang eines Störsignals. Ein mit den Empfangsantennen verbundener Empfänger ist dazu ausgelegt, das mit der zweiten Empfangsantenne empfangene Störsignal in dem von der ersten Empfangsantenne empfangenen Magnetresonanzsignal zu unterdrücken. Dazu wird das Störsignal während der MRT-Sequenzen zur Signalakquisition bestimmt, wobei Zeitabschnitte genutzt werden können, in denen kein MRT-Signal zur Bildgebung erwartet wird. Eine Entstörsteuerung kann dann die Signale der ersten Empfangsspule und der zweiten Empfangsspule gewichtet kombinieren, um die Energie des Störsignals in dem kombinierten Signal zu minimieren.

Da diese Abschnitte je nach verwendeter MRT-Sequenz unterschiedlich lang sind und zu unterschiedlichen Zeiten auftreten, muss das Vorgehen zur Entstörung individuell auf jede MRT-Sequenz angepasst werden, was zu einem erhöhten Aufwand führt. Zudem kann es je nach MRT-Sequenz möglich sein, dass die zur Verfügung stehenden Abschnitte zur Bestimmung des Störsignals nicht ausreichend lang sind, um eine zuverlässige Unterdrückung des Einflusses der Störung zu erreichen.

Aus dem Dokument US 2018/0143272 Al ist ein Verfahren zur Störsignalunterdrückung bei einem Magnetresonanzsystem mit einer Empfangsantenne bekannt. Das Verfahren umfasst den Schritt, Magnetresonanzdaten mit einem Störsignalanteil mit der Empfangsantenne und Störsignaldaten charakteristische für Störsignale in der Umgebung des Magnetresonanzsystems zu erfassen. Ein Kompensationsfaktor wird anhand der Störsignaldaten und eines auf Randbereiche des k-Raums beschränkten MR-Signaldaten ermittelt. Ein Störsignalanteil der Magnetresonanzdaten wird durch Multiplikation des Störsignals mit dem Kompensationsfaktor abgeschätzt und es werden durch Subtraktion des abgeschätzten Störsignalanteils von den Magnetresonanzdaten korrigierte Magnetresonanzdaten bereitgestellt.

Das Dokument US 2017/0108569 A1 beschreibt ein Magnetresonanzsystem zum Erfassen von Magnetresonanzdaten aus einem Bilderfassungsbereich. Es werden Magnetresonanzdaten für die Abbildung mit aktiver Anregung durch einen Radiofrequenzpuls erfasst. Weiterhin werden Störsignaldaten mit mindestens einer Störsignalerfassungsantenne gleichzeitig mit den Magnetresonanzdaten erfasst. Magnetresonanzdaten zur Kalibrierung werden mit deaktivierter Anregung erfasst und gleichzeitig Referenz-Störsignaldaten mit der Störsignalerfassungsantenne. Eine Störsignal-Kalibrierung wird mit den Referenz-Störsignaldaten und den Magnetresonanzdaten zur Kalibrierung berechnet.

Aus dem Dokument EP 3723037 A1 ist eine Medizindaten-Verarbeitungsvorrichtung bekannt, die eine erste Recheneinheit aufweist. Die erste Recheneinheit ermittelt eine Störsignalintensität aus ersten Daten, die während eines ersten Scanvorgangs erfasst wurden. Eine zweite Recheneinheit ermittelt eine Störunterdrückungsintensität für einen Entstörprozess aufgrund der Störsignalintensität und der Differenz zwischen einer Bilderfassungsbedingung für den ersten Scanvorgang und einer Bilderfassungsbedingung für einen zweiten Scanvorgang, wobei der Entstörprozess auf zweite Daten angewendet wird, die bei dem zweiten Scanvorgang gewonnen werden.

Das Dokument EP 3470868 A1 offenbart ein Magnetresonanzsystem zum Erfassen einer Reihe von Magnetresonanzdaten, die eine quantitative Abbildung einer Relaxationszeit bei einem Untersuchungsobjekt angeben. Die Magnetdaten werden mit Sequenzen erfasst, die Pausenabschnitte aufweisen, in denen Störsignale erfasst werden. In den Pausenabschnitten erfolgt keine Hochfrequenzanregung.

Vor diesem Hintergrund ist es eine Aufgabe der vorliegenden Erfindung, ein verbessertes Konzept für ein MRT-System beziehungsweise für ein Verfahren zum Betreiben eines solchen anzugeben, durch das der Aufwand für eine Abschirmung externer Störsignale reduziert werden kann und gleichzeitig eine hohe Effektivität der Störungsreduzierung, insbesondere bei möglichst geringem Anpassungsaufwand, möglich ist.

Diese Aufgabe wird vorliegend gelöst durch den jeweiligen Gegenstand der unabhängigen Ansprüche. Vorteilhafte Weiterbildungen und bevorzugte Ausführungsformen sind Gegenstand der abhängigen Ansprüche.

Das verbesserte Konzept beruht auf der Idee, zwei voneinander verschiedene MR-Aufnahmen durchzuführen, um jeweils MR-Daten zu erzeugen, die jedenfalls zum Teil ein Objekt darstellen und abhängig von den verschiedenen MR-Daten einen Störanteil zu bestimmen, der den Einfluss einer externen Störquelle repräsentiert.

Gemäß dem verbesserten Konzept wird ein Verfahren zum Betreiben eines MRT-Systems angegeben. Eine erste MR-Aufnahme zur Abbildung eines Objekts wird durchgeführt, insbesondere mittels des MRT-Systems, um erste MR-Daten zu erzeugen, die das Objekt darstellen. Die erste MR-Aufnahme wird dabei gemäß einem ersten k-Raum-Abtastschema durchgeführt und während der ersten MR-Aufnahme wird, insbesondere mittels wenigstens einer Sendeantenne des MRT-Systems, wenigstens ein erster Anregungspuls gemäß einer ersten Pulssequenz in Richtung des Objekts ausgesendet. Es wird eine von der ersten MR-Aufnahme verschiedene zweite MR-Aufnahme durchgeführt, insbesondere mittels des MRT-Systems, um von den ersten MR-Daten verschiedene zweite MR-Daten zu erzeugen. Abhängig von den zweiten MR-Daten wird mittels einer Recheneinheit, insbesondere einer Recheneinheit des MRT-Systems, ein Störanteil bestimmt, der einen Einfluss wenigstens einer externen Störquelle repräsentiert, insbesondere einen Einfluss der wenigstens einen externen Störquelle auf die ersten MR-Daten. Mittels der Recheneinheit wird abhängig von den ersten MR-Daten und abhängig von dem Störanteil ein MR-Bild erzeugt.

Während der ersten MR-Aufnahme wird also der wenigstens eine Anregungspuls geschaltet, sodass Kernspins des Objekts um die Ausrichtungsachse gemäß dem statischen Magnetfeld präzedieren und deren Resonanz zu MR-Signalen führt, die mittels einer oder mehrerer Empfangsantennen des MRT-Systems detektiert werden können, um die ersten MR-Daten zu erzeugen. Die ersten MR-Daten werden dabei durch die wenigstens eine externe Störquelle beeinflusst, sodass der Störanteil in den ersten MR-Daten vorhanden ist.

Analog werden während der zweiten MR-Aufnahme zweite Anregungspulse geschaltet, um entsprechende MR-Signale zu erhalten und die zweiten MR-Daten zu erzeugen. In diesem Fall wird die zweite MR-Aufnahme verschieden von der ersten MR-Aufnahme durchgeführt. In anderen nicht beanspruchten Ausführungsformen wird während der zweiten MR-Aufnahme kein Anregungspuls geschaltet, sodass lediglich der Einfluss der externen Störquelle durch die zweiten MR-Daten repräsentiert ist.

Es wird darauf hingewiesen, dass weder die erste MR-Aufnahme noch die zweite MR-Aufnahme notwendigerweise eine vollständige MR-Aufnahme darstellen, sodass die ersten MR-Daten und die zweiten MR-Daten nicht notwendigerweise alleine ausreichen, um das MR-Bild, insbesondere ein Ortsraumbild, zu erzeugen. Insbesondere wird während der ersten und/oder der zweiten MR-Aufnahme nicht notwendigerweise der komplette für die Bildgebung abzutastende k-Raum-Bereich abgetastet. Vielmehr können weitere erste MR-Aufnahmen und/oder weitere zweite MR-Aufnahmen durchgeführt werden, um eine für die erforderliche Bildgebung vollständige Abtastung zu realisieren. Es ist aber auch möglich, dass bereits durch die erste MR-Aufnahme eine vollständige Abtastung realisiert wird.

Eine Pulssequenz ist hier und im Folgenden insbesondere durch einen oder mehrere Zeitparameter, beispielsweise eine Echozeit TE und/oder eine Repetitionszeit TR, charakterisiert. Gegebenenfalls können weitere Parameter zur Definition einer Pulssequenz beitragen.

Unter einem k-Raum-Abtastschema kann hier und im Folgenden ein Schema verstanden werden, das beinhaltet, welche Punkte oder Bereiche im k-Raum abgetastet werden und in welcher Reihenfolge dies geschieht. Ein k-Raum-Abtastschema kann beispielsweise ein kartesisches k-Raum-Abtastschema, ein radiales k-Raum-Abtastschema, ein spiralförmiges k-Raum-Abtastschema und so weiter sein.

Der Störanteil kann außer dem Einfluss der wenigstens einen externen Störquelle auch einen Einfluss von thermischem Rauschen beinhalten.

Das MR-Bild, das abhängig von den ersten MR-Daten und dem Störanteil erzeugt wird, entspricht insbesondere einem entstörten k-Raum-Bild oder einem Ortsraumbild.

Der Störanteil kann beispielsweise abhängig von den zweiten MR-Daten und unabhängig von den ersten MR-Daten bestimmt werden. Alternativ kann der Störanteil abhängig von sowohl den ersten MR-Daten als auch den zweiten MR-Daten erzeugt beziehungsweise bestimmt werden.

Dass sich die zweite MR-Aufnahme von der ersten MR-Aufnahme unterscheidet, ist im Rahmen der vorliegenden Erfindung derart zu verstehen, dass für die zweite MR-Aufnahme Parameter verwendet werden, die sich von entsprechenden Parametern für die erste MR-Aufnahme unterscheiden. Beispielsweise kann die zweite MR-Aufnahme gemäß einem von dem ersten k-Raum-Abtastschema verschiedenen zweiten k-Raum-Abtastschema durchgeführt werden. Ein zweiter Anregungspuls wird gemäß einer zweiten Pulssequenz während der zweiten MR-Aufnahme in Richtung des Objekts ausgesendet werden, wobei sich die zweite Pulssequenz von der ersten Pulssequenz unterscheidet und/oder wobei sich der wenigstens eine zweite Anregungspuls von dem wenigstens einen ersten Anregungspuls unterscheidet.

Bei der wenigstens einen externen Störquelle handelt es sich insbesondere um wenigstens eine im Wesentlichen statische Störquelle. Dies kann derart verstanden werden, dass sich der Einfluss der wenigstens einen externen Störquelle von der ersten MR-Aufnahme zu der zweiten MR-Aufnahme nicht oder im Wesentlichen nicht verändert. Insbesondere bedeutet statische Störquelle nicht notwendigerweise, dass die Wirkung der statischen Störquelle dauerhaft unverändert ist. Je näher die erste und die zweite MR-Aufnahme beieinanderliegen, desto weniger macht sich eine zeitliche Veränderung des Einflusses beziehungsweise der Wirkung der wenigstens einen externen Störquelle bemerkbar.

Gemäß einem erfindungsgemäßen Verfahren nach dem verbesserten Konzept wird die zweite MR-Aufnahme gemäß einem zweiten k-Raum-Abtastschema durchgeführt, das sich von dem ersten k-Raum-Abtastschema unterscheidet.

Erfindungsgemäß wird während der zweiten MR-Aufnahme, insbesondere mittels der wenigstens einen Sendeantenne, wenigstens ein zweiter Anregungspuls gemäß einer zweiten Pulssequenz ihn Richtung des Objekts ausgesendet. Der zweite MR-Datensatz stellt dann das Objekt ebenfalls dar. Die zweite Pulssequenz kann dabei identisch zur ersten Pulssequenz sein oder verschieden von der ersten Pulssequenz.

Da sich gemäß dem erwähnten erfindungsgemäßen Verfahren das zweite k-Raum-Abtastschema von dem ersten k-Raum-Abtastschema unterscheidet, unterscheiden sich auch die ersten MR-Daten von den zweiten MR-Daten. Der Einfluss der externen Störquelle ist jedoch auf die ersten MR-Daten und auf die zweiten MR-Daten näherungsweise gleich. Dadurch, dass sich die k-Raum-Abtastschemata unterscheiden, der Einfluss der Störquelle jedoch nicht wesentlich, lassen sich durch Korrelation der ersten MR-Daten und der zweiten MR-Daten miteinander die Einflüsse der externen Störquelle in Form des Störanteils bestimmen. Insbesondere wird der Störanteil in solchen Ausführungsformen abhängig von den ersten MR-Daten und den zweiten MR-Daten bestimmt.

Ein solches erfindungsgemäßes Verfahren hat außerdem den Vorteil, dass auch die zweiten MR-Daten zur Erzeugung des MR-Bildes verwendet werden können, sodass die für die zweite MR-Aufnahme aufgewendete zusätzliche Zeit noch effizienter genutzt werden kann.

Gemäß dem erfindungsgemäßen Verfahren nach Anspruch 1 unterscheiden sich die erste und die zweite Pulssequenz voneinander. Im Rahmen dieses erfindungsgemäßen Verfahrens ist die erste Pulssequenz durch einen ersten Zeitparametersatz definiert und die zweite Pulssequenz ist durch einen zweiten Zeitparametersatz definiert, der sich von dem ersten Zeitparametersatz unterscheidet.

Der erste Zeitparametersatz beinhaltet eine erste Echozeit und/oder eine erste Repetitionszeit. Die zweite Pulssequenz beinhaltet dementsprechend eine zweite Echozeit und eine zweite Repetitionszeit. Die erste und die zweite Echozeit unterscheiden sich dabei voneinander und/oder die erste und die zweite Repetitionszeit unterscheiden sich voneinander.

Erfindungsgemäß unterscheidet sich ein erstes Verhältnis der ersten Echozeit zur ersten Repetitionszeit von einem zweiten Verhältnis der zweiten Echozeit zur zweiten Repetitionszeit. Somit werden für die erste und die zweite MR-Aufnahme jeweils unterschiedliche Kontraste realisiert. Dadurch korrelieren die MR-Signalanteile der ersten und der zweiten MR-Daten noch weniger miteinander, sodass der Störanteil noch besser extrahiert werden kann, insbesondere durch Korrelation der ersten mit den zweiten MR-Daten.

Das MR-Bild wird dabei abhängig von den ersten MR-Daten und abhängig von den zweiten MR-Daten erzeugt.

Dadurch lässt sich eine höhere Genauigkeit des resultierenden MR-Bildes erreichen und gleichzeitig der Einfluss der externen Störquelle reduzieren.

Durch das verbesserte Konzept werden also unterschiedliche MR-Daten, nämlich die ersten MR-Daten und die zweiten MR-Daten, in verschiedenen MR-Aufnahmen erzeugt. Da sich die Wirkung der externen Störquellen jedoch nicht oder im Wesentlichen nicht verändert, ist der Einfluss der wenigstens einen Störquelle auf die ersten MR-Daten näherungsweise gleich dem Einfluss der externen Störquelle auf die zweiten MR-Daten. Je nach Ausgestaltungsform der zweiten MR-Aufnahme kann daher beispielsweise durch Korrelation der ersten MR-Daten mit den zweiten MR-Daten oder basierend auf den zweiten MR-Daten allein der Störanteil bestimmt werden. Der so bestimmte Störanteil kann dann wenigstens zum Teil aus den ersten und/oder den zweiten MR-Daten entfernt werden, um das MR-Bild zu erzeugen und so den Einfluss der wenigstens einen externen Störquelle zu kompensieren. Die Entfernung oder Reduktion des Störanteils kann dabei im Ortsraum oder im k-Raum oder in einem Hybridraum erfolgen. Die Entfernung des Störanteils oder die Reduktion des Störanteils kann aber auch teilweise im k-Raum und teilweise im Ortsraum durchgeführt werden und so weiter.

Dadurch, dass gemäß dem verbesserten Konzept der Störanteil in situ für die aktuell konkret vorliegende Störerumgebung bestimmt wird, ist eine besonders effektive Unterdrückung des Einflusses der externen Störquellen möglich. Insbesondere ist es gemäß dem verbesserten Konzept nicht notwendig, spezielle Zeitabschnitte während der MR-Aufnahmen, insbesondere während der ersten MR-Aufnahme, auszunutzen, während denen kein MR-Signal zu erwarten ist. Das verbesserte Konzept ist daher universell für unterschiedlichste erste k-Raum-Abtastschemata und/oder erste Pulssequenzen anwendbar.

Schließlich kann durch das verbesserte Konzept auch auf die Verwendung von Abschirmkabinen zum Abschirmen von externen Störeinflüssen verzichtet werden oder die Abschirmkabinen können einfacher ausgestaltet werden, was Bauraum und/oder Kosten einsparen kann. Ein weiterer Vorteil des verbesserten Konzepts ist, dass auch keine zusätzlichen Empfangsantennen eingesetzt werden müssen, mit denen dediziert der Störanteil erfasst werden könnte. Auch dadurch können Bauraum und Kosten weiter eingespart werden.

Gemäß zumindest einer Ausführungsform wird mittels der Recheneinheit abhängig von den ersten MR-Daten und den zweiten MR-Daten ein Signalzerlegungsalgorithmus durchgeführt, um den Störanteil zu bestimmen.

Der Signalzerlegungsalgorithmus kann beispielsweise einen Algorithmus zur Hauptkomponentenanalyse, PCA (englisch: "Principal Component Analysis") oder einen Algorithmus zur Unabhängigkeitsanalyse, ICA (englisch: "Independent Component Analysis"), beinhalten.

Gemäß zumindest einer Ausführungsform , welche nicht Teil der vorliegenden Erfindung ist, wird die zweite MR-Aufnahme gemäß dem ersten k-Raum-Abtastschema durchgeführt, also insbesondere nicht gemäß dem zweiten k-Raum-Abtastschema. Während der zweiten MR-Aufnahme wird, insbesondere mittels der wenigstens einen Sendeantenne, kein Anregungspuls in Richtung des Objekts ausgesendet.

In solchen Ausführungsformen , welche nicht Teil der vorliegenden Erfindung sind, wird das MR-Bild insbesondere unabhängig von den zweiten MR-Daten erzeugt. Die zweiten MR-Daten stellen in diesem Fall das Objekt nämlich nicht dar. Die zweite MR-Aufnahme dient in solchen Ausführungsformen lediglich dazu, den Störanteil zu erfassen.

Solche Ausführungsformen haben jedoch den Vorteil, dass der Störanteil unabhängig von den ersten MR-Daten bestimmt werden kann. Da während der zweiten Aufnahme kein Anregungspuls ausgesendet wird, ist entsprechend auch kein MR-Signal von dem Objekt zu erwarten, sodass die zweiten MR-Daten den Störanteil besonders genau wiedergeben.

Gemäß dem Verfahren nach Anspruch 2 entspricht das erste k-Raum-Abtastschema einem kartesischen Abtastschema und das zweite k-Raum-Abtastschema entspricht einem radialen Abtastschema oder einem spiralförmigen Abtastschema oder einem Wave-CAIPIRINHA-Abtastschema.

Gemäß dem verbesserten Konzept wird auch ein MRT-System angegeben, das eine Scannereinheit aufweist, die dazu eingerichtet ist, ein erste MR-Aufnahme zur Abbildung eines Objekts gemäß einem ersten k-Raum-Abtastschema durchzuführen, um erste MR-Daten zu erzeugen, die das Objekt darstellen, wobei während der ersten MR-Aufnahme, insbesondere mittels einer oder mehrerer Sendeantennen des MRT-Systems, wenigstens ein erster Anregungspuls gemäß einer ersten Pulssequenz in Richtung des Objekts ausgesendet wird. Die Scannereinheit ist dazu eingerichtet, eine von der ersten MR-Aufnahme verschiedene zweite MR-Aufnahme durchzuführen, um zweite MR-Daten zu erzeugen. Das MRT-System weist außerdem eine Recheneinheit auf, die dazu eingerichtet ist, abhängig von den zweiten MR-Daten einen Störanteil zu bestimmen, der einen Einfluss wenigstens einer externen Störquelle repräsentiert und abhängig von den ersten MR-Daten und dem Störanteil ein MR-Bild zu erzeugen.

Die Scannereinheit kann beispielsweise eine Magneteinheit beinhalten. Die Magneteinheit kann einen Feldmagneten zum Erzeugen eines statischen Magnetfelds beinhalten sowie eine oder mehrere Gradientenspulen zum Erzeugen von zeitabhängigen Magnetfeldgradienten, insbesondere in die Richtung der drei verschiedenen Raumrichtungen. Die Scannereinheit beinhaltet beispielsweise außerdem eine Hochfrequenzeinheit zum Erzeugen des wenigstens einen Anregungspulses mittels der wenigstens einen Sendeantenne. Die wenigstens eine Sendeantenne kann ebenfalls Teil der Scannereinheit sein. Eine Steuereinheit der Scannereinheit kann die genannten Komponenten entsprechend ansteuern oder versorgen, um die MR-Aufnahmen wie beschrieben durchzuführen.

Weitere Ausführungsformen des MRT-Systems nach dem verbesserten Konzept folgen direkt aus den verschiedenen Ausgestaltungsformen des Verfahrens nach dem verbesserten Konzept und umgekehrt. Insbesondere ist ein MRT-System nach dem verbesserten Konzept dazu eingerichtet, ein Verfahren nach dem verbesserten Konzept durchzuführen oder führt ein solches Verfahren durch.

Gemäß dem verbesserten Konzept wird auch ein Computerprogramm mit Befehlen angegeben. Bei Ausführung der Befehle beziehungsweise des Computerprogramms durch ein MRT-System nach dem verbesserten Konzept veranlassen die Befehle das MRT-System dazu, ein Verfahren nach dem verbesserten Konzept durchzuführen.

Gemäß dem verbesserten Konzept wird auch ein computerlesbares Speichermedium angegeben, welches das Computerprogramm nach dem verbesserten Konzept speichert.

Das Computerprogramm sowie das computerlesbare Speichermedium können jeweils als Computerprogrammprodukte mit den Befehlen bezeichnet werden.

Die vorstehend in der Beschreibung genannten Merkmale und Merkmalskombinationen sowie die nachfolgend in der Figurenbeschreibung genannten und/oder in den Figuren alleine gezeigten Merkmale und Merkmalskombinationen sind nicht nur in der jeweils angegebenen Kombination, sondern auch in anderen Kombinationen verwendbar, ohne den Rahmen der Erfindung zu verlassen, welcher durch die Ansprüche gegeben ist. Es sind auch Ausführungen und Merkmalskombinationen als offenbart anzusehen, die nicht alle Merkmale eines ursprünglich formulierten unabhängigen Anspruchs aufweisen und/oder die über die in den Rückbezügen der Ansprüche dargelegten Merkmalskombinationen hinausgehen oder von denen abweichen. Der Schutzumfang der Erfindung ist jedoch durch die Ansprüche bestimmt.

In den Figuren zeigen:

FIG 1 eine schematische Darstellung einer beispielhaften Ausführungsform eines MRT-Systems gemäß dem verbesserten Konzept;

FIG 2 ein Ablaufdiagramm einer beispielhaften Ausführungsform eines Verfahrens nach dem verbesserten Konzept;

FIG 3 schematische k-Raum-Darstellungen von Einflüssen einer externen Störstelle; und

FIG 4 schematische Ortsraumdarstellungen von Einflüssen einer externen Störstelle.

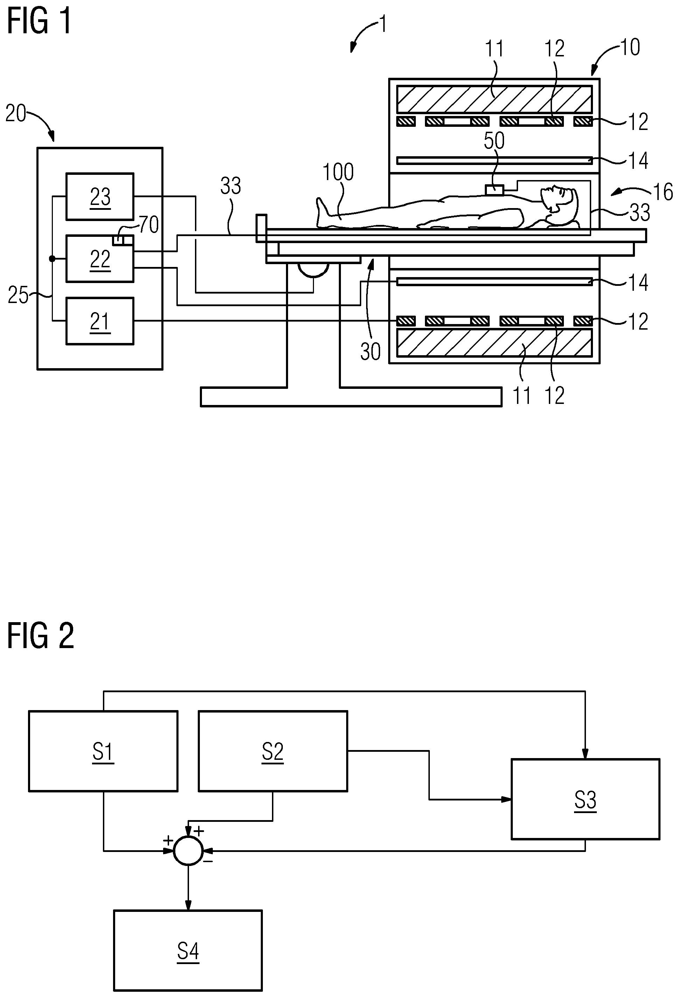

FIG 1 zeigt eine schematische Darstellung einer beispielhaften Ausführungsform eines MRT-Systems 1 gemäß dem verbesserten Konzept.

Das MRT-System 1 weist eine Magneteinheit 10 mit einem Feldmagneten 11 auf, der ein statisches Magnetfeld zur Ausrichtung von Kernspins einer Probe, beispielsweise eines Patienten 100, in einem Untersuchungsbereich oder Aufnahmebereich erzeugt. Der Patient 100 kann sich dabei beispielsweise auf einer Patientenliege 30 befinden. Der Aufnahmebereich zeichnet sich durch ein äußerst homogenes statisches Magnetfeld auf, wobei die Homogenität insbesondere die Magnetfeldstärke beziehungsweise deren Betrag betrifft. Der Aufnahmebereich ist beispielweise nahezu kugelförmig und in einem Patiententunnel 16 positioniert, der sich in einer Längsrichtung 2 durch die Magneteinheit 10 erstreckt. Bei dem Feldmagneten 11 kann es sich beispielsweise um einen supraleitenden Magneten handelt, der magnetische Felder mit einer magnetischen Flussdichte von bis zu 3 T oder mehr bereitstellen kann. Für geringere Feldstärken können jedoch auch Permanentmagnete oder Elektromagnete mit normalleitenden Spulen Verwendung finden.

Weiterhin weist die Magneteinheit 10 Gradientenspulen 12 auf, die dazu ausgelegt sind, zur räumlichen Differenzierung der erfassten Abbildungsbereiche in dem Aufnahmebereich dem statischen Magnetfeld ortsabhängige Magnetfelder in den drei Raumrichtungen zu überlagern. Die Gradientenspulen 12 können beispielsweise als Spulen aus normalleitenden Drähten ausgestaltet sein, die beispielsweise zueinander orthogonale Felder oder Feldgradienten in dem Aufnahmebereich erzeugen können.

Die Magneteinheit 10 kann als Sendeantenne beispielsweise eine Körperspule 14 aufweisen, die dazu ausgelegt ist, ein über eine Signalleitung zugeführtes Hochfrequenzsignal in den Untersuchungsbereich abzustrahlen. Die Körperspule 14 kann in manchen Ausführungsformen auch dazu genutzt werden, von dem Patienten 100 emittierte Resonanzsignale zu empfangen und über eine Signalleitung abzugeben.

Das MRT-System 1 weist eine Steuereinheit 20 auf, die die Magneteinheit 10 mit verschiedenen Signalen für die Gradientenspulen 12 und die Körperspule 14 versorgen kann und die empfangenen Signale auswerten kann. Die Steuereinheit 20 kann beispielsweise eine Gradientensteuerung 21 aufweisen, die dazu ausgelegt ist, die Gradientenspulen 12 über Zuleitungen mit variablen Strömen zu versorgen, welche zeitlich koordiniert die gewünschten Gradientenfelder in dem Untersuchungsbereich bereitstellen können.

Die Steuereinheit 20 kann auch eine Hochfrequenzeinheit 22 aufweisen, die dazu ausgelegt ist, Hochfrequenzpulse oder Anregungspulse mit vorgegebenen zeitlichen Verläufen, Amplituden und spektraler Leistungsverteilung zur Anregung einer Magnetresonanz der Kernspins in dem Patienten 100 zu erzeugen. Dabei können Pulsleistungen im Bereich von Kilowatt eingesetzt werden. Die Anregungspulse können über die Körperspule 14 oder über eine oder mehrere lokale Sendeantennen in den Patienten 100 abgestrahlt werden. Die Steuereinheit 20 kann auch eine Steuerung 23 enthalten, die über einen Signalbus 25 mit der Gradientensteuerung 21 und der Hochfrequenzeinheit 22 kommunizieren kann.

Optional kann in der unmittelbaren Umgebung des Patienten 100, beispielsweise auf dem Patienten 100 oder in der Patientenliege 30, eine Lokalspule 50 angeordnet sein, die über eine Anschlussleitung 33 mit der Hochfrequenzeinheit 22 verbunden sein kann. Je nach Ausgestaltungsform kann die Lokalspule 50 alternativ oder zusätzlich zur Körperspule 14 als Empfangsantenne dienen.

Die Empfangsantennen 14, 50 stehen beispielsweise in einer Signalverbindung mit einer Recheneinheit 70, die beispielsweise Teil eines Empfängers der Steuereinheit 20 ist. Die Recheneinheit 70 kann beispielsweise eine programmierbare Logikeinheit, beispielsweise ein feldprogrammierbares Gate-Array, FPGA, oder einen digitalen Signalprozessor, DSP, beinhalten.

Die Funktionsweise des MRT-Systems 1 wird im Folgenden unter Bezugnahme auf exemplarische Ausführungsformen eines Verfahrens zum Betreiben eines MRT-Systems nach dem verbesserten Konzept genauer erläutert, insbesondere unter Bezugnahme auf die Figuren FIG 2 bis FIG 4.

In FIG 2 ist ein schematisches Ablaufdiagramm einer beispielhaften Ausführungsform eines Verfahrens nach dem verbesserten Konzept dargestellt.

Im Schritt S1 wird mittels des MRT-Systems 1 eine erste MR-Aufnahme zur Abbildung des Patienten 100 durchgeführt. Durch die erste MR-Aufnahme werden erste MR-Daten erzeugt. Die erste MR-Aufnahme wird dabei gemäß einem ersten k-Raum-Abtastschema durchgeführt. Um den Patienten 100 durch die ersten MR-Daten darzustellen, werden während der ersten MR-Aufnahme Anregungspulse gemäß einer ersten Pulssequenz, insbesondere mittels der Körperspule 14, emittiert.

In Schritt S2 wird mittels des MRT-Systems 1 eine von der ersten MR-Aufnahme verschiedene zweite MR-Aufnahme durchgeführt, um zweite MR-Daten zu erzeugen. Im Schritt S3 wird mittels der Recheneinheit 70 ein Störanteil bestimmt, der einen Einfluss wenigstens einer externen Störquelle (nicht dargestellt) repräsentiert. Der Störanteil wird dabei abhängig von den zweiten MR-Daten und zusätzlich abhängig von den ersten MR-Daten bestimmt. In Schritt S4 erzeugt die Recheneinheit 70 abhängig von den ersten MR-Daten und dem Störanteil und abhängig von den zweiten MR-Daten ein MR-Bild.

In verschiedenen Ausführungsformen kann die erste MR-Aufnahme beispielsweise gemäß einer ersten Codierung mit einer kartesischen k-Raum-Abtastung durchgeführt werden.

Die zweite MR-Aufnahme wird ebenfalls genutzt, um den Patienten 100 darzustellen, um somit die finale MR-Bildqualität zu verbessern und die doppelte Messzeit effizienter auszunutzen. Dabei werden während der zweiten MR-Aufnahme insbesondere gemäß einer zweiten Pulssequenz wenigstens ein zweiter Anregungspuls ausgesendet. Die zweite MR-Aufnahme erfolgt gemäß einem zweiten k-Raum-Abtastschema, das sich von dem ersten k-Raum-Abtastschema unterscheidet.

Je weniger korreliert die beiden Codierungsstrategien für die erste und die zweite MR-Aufnahme zueinander sind, desto stärker unterscheiden sich die resultierenden MR-Signale. Beispielsweise sind Kombinationen mit Wave-CAIPIRINHA-Codierungen denkbar, die in der finalen Bildrekonstruktion zu einer verbesserten Bildqualität beitragen können.

Dabei haben sowohl die ersten MR-Daten als auch die zweite MR-Daten Beiträge von MR-Signalen aus dem Patienten 100. Der Störanteil korreliert zwischen den ersten und den zweiten MR-Daten und kann mittels geeigneter

Signalzerlegungsalgorithmen, beispielsweise PCA-Algorithmen oder ICA-Algorithmen, extrahiert werden. Dabei können beispielsweise alle Lokalspulenkanäle aus beiden Codierungsstrategien gemeinsam analysiert werden, um den gemeinsamen Störanteil aus den unkorrelierten MR-Signalcodierungen zu bestimmen. Der Störanteil kann dementsprechend sowohl von den ersten MR-Daten als auch von den zweiten MR-Daten entfernt werden.

Da sowohl die ersten als auch die zweiten MR-Daten nun MR-Signalanteile beinhalten, können beide in einem gemeinsamen Rekonstruktionsprozess verbunden werden, um das MR-Bild zu erzeugen. Dadurch können die Gesamtbildqualität beziehungsweise das Signal-zu-Rausch-Verhältnis verbessert werden. Ferner können Variationen der externen Störquellen zwischen den einzelnen Aufnahmen noch weiter unterdrückt werden.

Beispielsweise kann das finale MR-Bild ausgedrückt werden durch $X = X_1 + \alpha * X_2$, wobei $X_1$ und $X_2$ den basierend auf den ersten beziehungsweise zweiten MR-Daten rekonstruierten Ortsraumbildern entsprechen, die variiert werden, um eine Kostenfunktion K minimieren. $\alpha$ stellt einen konstanten Gewichtungsfaktor dar. Die Kostenfunktion K kann beispielsweise gegeben sein durch

$$K = K(X_1, X_2) = |S_1 - T_1(X_1)| + \alpha*|S_2 - T_2(X_2)| + \alpha'*|X_1 - X_2|.$$

Dabei stehen $S_1$ und $S_2$ für die anhand des Signalzerlegungsalgorithmus bereinigten ersten beziehungsweise zweiten MR-Daten das und $T_1$ beziehungsweise $T_2$ den jeweiligen inversen Rekonstruktionskernel, der im einfachsten Fall durch eine Fouriertransformation gegeben sein kann. $\alpha'$ stellt einen weiteren Gewichtungsfaktor dar, um Unterschiede zwischen den beiden Kodierungen gegebenenfalls stärker zu unterdrücken.

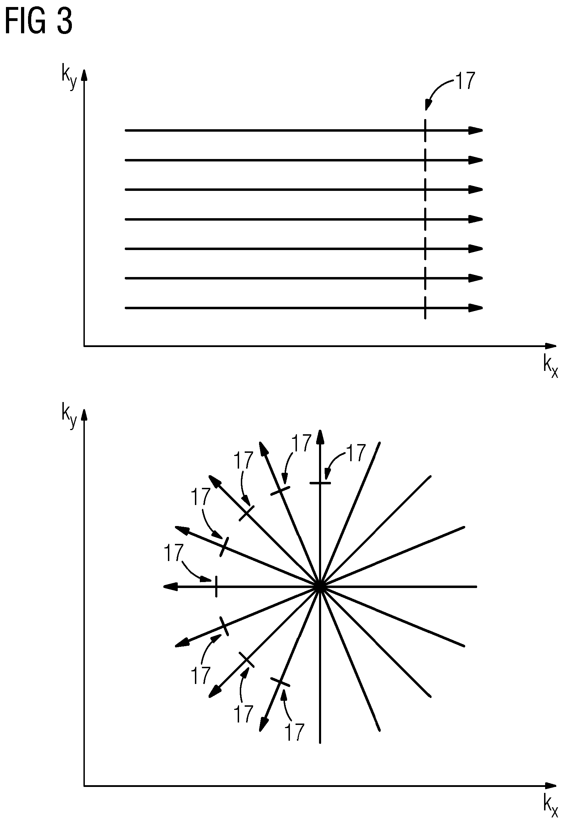

In FIG 3 ist schematisch der Einfluss 17 der externen Störquellen im k-Raum für unterschiedliche Codierungsstrategien dargestellt. Die Abbildung links in FIG 3 entspricht beispielsweise einer kartesischen k-Raum-Abtastung, wobei beispielsweise eine externe Störquelle mit näherungsweise monofrequenter Abstrahlcharakteristik angenommen wird. Der Einfluss 17 macht sich nun in jeder k-Raum-Zeile an derselben Position bemerkbar. In der rechten Abbildung von FIG 3 ist dem ein radiales k-Raum-Abtastschema gegenübergestellt. Die Einflüsse 17 der externen Störquellen sind durch die unterschiedliche Codierungsstrategie an unterschiedlichen Positionen im k-Raum sichtbar.

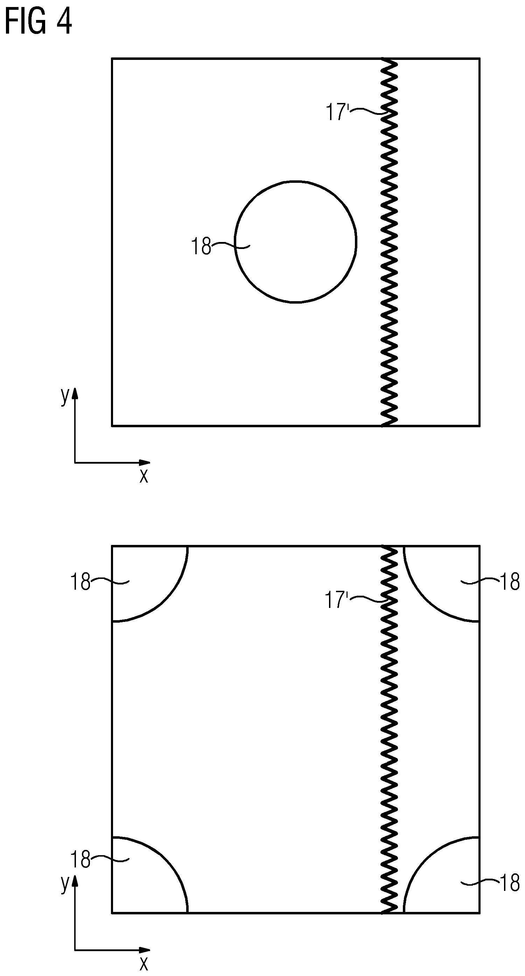

In FIG 4 ist eine vereinfachte Darstellung von Einflüssen 17' einer weiteren externen Störquelle für unterschiedliche Codierungsstrategien im Ortsraum dargestellt. In der linken Abbildung der FIG 4 wird eine erste Codierungsstrategie eingesetzt, rechts eine zweite Codierungsstrategie, bei der die MR-Signale eine zusätzliche Frequenz- und Phasenverschiebung erhalten, den die Einflüsse 17' der externen Störquelle jedoch nicht erfahren. Ein Objekt 18, das dementsprechend in den beiden MR-Aufnahmen abgebildet wird, wird in den beiden Ortsraumdarstellungen daher unterschiedlich dargestellt. Die Einflüsse 17' der externen Störquellen sind jedoch in beiden Ortsraumbilder im Wesentlichen gleich.

Wie bezüglich FIG 3 und FIG 4 exemplarisch erläutert, erlaubt es das verbesserte Konzept, die korrelierenden Störeinflüsse von den nicht-korrelierenden MR-Signalen zu trennen.

Wie beschrieben, insbesondere bezüglich der Figuren, wird durch das verbesserte Konzept also eine Möglichkeit zur Störungsreduzierung beim Betrieb eines MRT-Systems angegeben, durch das die Anforderungen an Abschirmvorrichtungen reduziert werden können und das eine zuverlässigere und effektivere Unterdrückung von Störeinflüssen erlaubt.

Da MRT-Systeme nach dem verbesserten Konzept ohne Abschirmkabinen oder mit weniger aufwändigen Abschirmkabinen auskommen, können die Kosten der Installation und insbesondere die Neuaufstellung eines Geräts an einem anderen Ort erheblich verringert werden, da die Installation wesentlich weniger von dem Gebäude abhängt, in dem es installiert wird.

Die Lokalspulen im Patiententunnel sind von der Umgebung mit zirka 20 bis 50 dB entkoppelt, da der Patiententunnel als Cut-off-Hohlleiter wirkt, jedenfalls bei Systemen mit einem statischen Magnetfeld von bis zu 3 T, und die Ausbreitung einer Welle vom Eintritt in den Patiententunnel bis zur Lokalspule so bereits unterdrückt wird. Die Effektivität der Unterdrückung steigt mit sinkender Frequenz bei gleichem Durchmesser des Patiententunnels. Allerdings wirkt der Patient, dessen Gewebe leicht leitfähig ist, als Monopolantenne, die aus dem Patiententunnel herausragt und bildet so zusammen mit Mantelstrukturen eine Koaxialstruktur. Somit können Störungen aufgefangen und zur Lokalspule geleitet werden. Ähnliche Effekte können durch die Spulenverkabelung, die aus dem Patiententunnel herausragt, verursacht werden. Durch das verbesserte Konzept können solche Effekte kompensiert oder abgeschwächt werden.

**Patentansprüche**

1. Verfahren zum Betreiben eines Magnetresonanztomographiesystems (1), wobei

- eine erste MR-Aufnahme zur Abbildung eines Objekts (100) durchgeführt wird, um erste MR-Daten zu erzeugen, die das Objekt (100) darstellen;
- die erste MR-Aufnahme gemäß einem ersten k-Raum-Abtastschema durchgeführt wird und während der ersten MR-Aufnahme wenigstens ein erster Anregungspuls gemäß einer ersten Pulssequenz in Richtung des Objekts (100) ausgesendet wird;
- eine von der ersten MR-Aufnahme verschiedene zweite MR-Aufnahme durchgeführt wird, um zweite MR-Daten zu erzeugen;
- abhängig von den zweiten MR-Daten mittels einer Recheneinheit (70) ein Störanteil bestimmt wird, der einen Einfluss wenigstens einer externen Störquelle repräsentiert; und
- mittels der Recheneinheit (70) abhängig von den ersten MR-Daten und dem Störanteil ein MR-Bild erzeugt wird,

wobei die zweite MR-Aufnahme gemäß einem zweiten k-Raum-Abtastschema durchgeführt wird, das sich von dem ersten k-Raum-Abtastschema unterscheidet,- während der zweiten MR-Aufnahme wenigstens ein zweiter Anregungspuls gemäß einer zweiten Pulssequenz in Richtung des Objekts ausgesendet wird, wobei sich die zweite Pulssequenz von der ersten Pulssequenz unterscheidet; und

- die zweiten MR-Daten das Objekt (100) darstellen und

wobei das MR-Bild abhängig von den zweiten MR-Daten erzeugt wird,
**dadurch gekennzeichnet, dass**

- die erste Pulssequenz durch einen ersten Zeitparametersatz definiert ist;
- die zweite Pulssequenz durch einen zweiten Zeitparametersatz definiert ist, der sich von dem ersten Zeitparametersatz unterscheidet,
wobei der erste Zeitparametersatz eine erste Echozeit und/oder eine erste Repetitionszeit beinhaltet und die zweite Pulssequenz eine zweite Echozeit und eine zweite Repetitionszeit, wobei sich die erste und die zweite Echozeit und/oder die erste und die zweite Repetitionszeit voneinander unterscheiden, wobei ein erstes Verhältnis der ersten Echozeit zur ersten Repetitionszeit sich von einem zweiten Verhältnis der zweiten Echozeit zur zweiten Repetitionszeit unterscheiden, sodass für die erste und die zweite MR-Aufnahme jeweils unterschiedliche Kontraste realisiert werden.

2. Verfahren zum Betreiben eines Magnetresonanztomographiesystems (1), wobei

- eine erste MR-Aufnahme zur Abbildung eines Objekts (100) durchgeführt wird, um erste MR-Daten zu erzeugen, die das Objekt (100) darstellen;
- die erste MR-Aufnahme gemäß einem ersten k-Raum-Abtastschema durchgeführt wird und während der ersten MR-Aufnahme wenigstens ein erster Anregungspuls gemäß einer ersten Pulssequenz in Richtung des Objekts (100) ausgesendet wird;
- eine von der ersten MR-Aufnahme verschiedene zweite MR-Aufnahme durchgeführt wird, um zweite MR-Daten zu erzeugen;
- abhängig von den zweiten MR-Daten mittels einer Recheneinheit (70) ein Störanteil bestimmt wird, der einen Einfluss wenigstens einer externen Störquelle repräsentiert; und
- mittels der Recheneinheit (70) abhängig von den ersten MR-Daten und dem Störanteil ein MR-Bild erzeugt wird, wobei die zweite MR-Aufnahme gemäß einem zweiten k-Raum-Abtastschema durchgeführt wird, das sich von dem ersten k-Raum-Abtastschema unterscheidet,
- während der zweiten MR-Aufnahme wenigstens ein zweiter Anregungspuls gemäß einer zweiten Pulssequenz in Richtung des Objekts ausgesendet wird, wobei sich die zweite Pulssequenz insbesondere von der ersten Pulssequenz unterscheidet; und
- die zweiten MR-Daten das Objekt (100) darstellen und

    wobei das MR-Bild abhängig von den zweiten MR-Daten erzeugt wird,
    **dadurch gekennzeichnet, dass**

    - das erste k-Raum-Abtastschema einem kartesischen Abtastschema entspricht; und
    - das zweite k-Raum-Abtastschema einem radialen Abtastschema oder einem spiralförmigen Abtastschema oder einem Wave-CAIPIRIHNA-Abtastschema entspricht.

3. Verfahren nach einem der Ansprüche 1 oder 2, wobei mittels der Recheneinheit (70) abhängig von den ersten MR-Daten und den zweiten MR-Daten ein Signalzerlegungsalgorithmus durchgeführt wird, um den Störanteil zu bestimmen.

4. Verfahren nach Anspruch 3, wobei der Signalzerlegungsalgorithmus einen Algorithmus zur Hauptkomponentenanalyse oder einen Algorithmus zur Unabhängigkeitsanalyse beinhaltet.

5. Magnetresonanztomographiesystem aufweisend eine Scannereinheit (10, 20), die dazu eingerichtet ist,

    - eine erste MR-Aufnahme zur Abbildung eines Objekts (100) gemäß einem ersten k-Raum-Abtastschema durchzuführen, um erste MR-Daten zu erzeugen, die das Objekt (100) darstellen, wobei während der ersten MR-Aufnahme wenigstens ein erster Anregungspuls gemäß einer ersten Pulssequenz in Richtung des Objekts (100) ausgesendet wird; und
    - eine von der ersten MR-Aufnahme verschiedene zweite MR-Aufnahme durchzuführen, um zweite MR-Daten zu erzeugen; sowie eine Recheneinheit (70), die dazu eingerichtet ist,
    - abhängig von den zweiten MR Daten einen Störanteil zu bestimmen, der einen Einfluss wenigstens einer externen Störquelle repräsentiert; und
    - abhängig von den ersten MR-Daten und dem Störanteil ein MR-Bild zu erzeugen,

    wobei die Scannereinheit dazu eingerichtet ist, die zweite MR-Aufnahme gemäß einem zweiten k-Raum-Abtastschema durchzuführen, das sich von dem ersten k-Raum-Abtastschema unterscheidet,
    wobei

    - die Scannereinheit dazu eingerichtet ist, während der zweiten MR-Aufnahme wenigstens ein zweiter Anregungspuls gemäß einer zweiten Pulssequenz in Richtung des Objekts auszusenden, wobei sich die zweite Pulssequenz
    von der ersten Pulssequenz unterscheidet; und
    - die zweiten MR-Daten das Objekt (100) darstellen und

    wobei die Scannereinheit dazu eingerichtet ist, das MR-Bild abhängig von den zweiten MR-Daten zu erzeugen,
    **dadurch gekennzeichnet, dass**

    - die erste Pulssequenz durch einen ersten Zeitparametersatz definiert ist;
    - die zweite Pulssequenz durch einen zweiten Zeitparametersatz definiert ist, der sich von dem ersten Zeitparametersatz unterscheidet,
    wobei der erste Zeitparametersatz eine erste Echozeit und/oder eine erste Repetitionszeit beinhaltet und die zweite Pulssequenz eine zweite Echozeit und eine zweite Repetitionszeit, wobei sich die erste und die zweite Echozeit und/oder die erste und die zweite Repetitionszeit voneinander unterscheiden, wobei ein erstes Verhältnis der ersten Echozeit zur ersten Repetitionszeit sich von einem zweiten Verhältnis der zweiten Echozeit zur zweiten Repetitionszeit unterscheiden, sodass für die erste und die zweite MR-Aufnahme jeweils unterschiedliche Kontraste realisiert werden.

6. Magnetresonanztomographiesystem aufweisend eine Scannereinheit (10, 20), die dazu eingerichtet ist,

- eine erste MR-Aufnahme zur Abbildung eines Objekts (100) gemäß einem ersten k-Raum-Abtastschema durchzuführen, um erste MR-Daten zu erzeugen, die das Objekt (100) darstellen, wobei während der ersten MR-Aufnahme wenigstens ein erster Anregungspuls gemäß einer ersten Pulssequenz in Richtung des Objekts (100) ausgesendet wird; und
- eine von der ersten MR-Aufnahme verschiedene zweite MR-Aufnahme durchzuführen, um zweite MR-Daten zu erzeugen; sowie eine Recheneinheit (70), die dazu eingerichtet ist,
- abhängig von den zweiten MR Daten einen Störanteil zu bestimmen, der einen Einfluss wenigstens einer externen Störquelle repräsentiert; und
- abhängig von den ersten MR-Daten und dem Störanteil ein MR-Bild zu erzeugen,

    wobei die Scannereinheit dazu eingerichtet ist, die zweite MR-Aufnahme gemäß einem zweiten k-Raum-Abtastschema durchzuführen,
    das sich von dem ersten k-Raum-Abtastschema unterscheidet,

- die Scannereinheit dazu eingerichtet ist, während der zweiten MR-Aufnahme wenigstens ein zweiter Anregungspuls gemäß einer zweiten Pulssequenz in Richtung des Objekts auszusenden, wobei sich die zweite Pulssequenz insbesondere von der ersten Pulssequenz unterscheidet; und
- die zweiten MR-Daten das Objekt (100) darstellen und

    wobei die Scannereinheit dazu eingerichtet ist, das MR-Bild abhängig von den zweiten MR-Daten zu erzeugen,
    **dadurch gekennzeichnet, dass**

- das erste k-Raum-Abtastschema einem kartesischen Abtastschema entspricht; und
- das zweite k-Raum-Abtastschema einem radialen Abtastschema oder einem spiralförmigen Abtastschema oder einem Wave-CAIPIRIHNA-Abtastschema entspricht.

7. Computerprogrammprodukt mit Befehlen, die bei Ausführung durch ein Magnetresonanztomographiesystem (1) nach Anspruch 5 oder 6 das Magnetresonanztomographiesystem (1) dazu veranlassen, ein Verfahren nach einem der Ansprüche 1 bis 4 durchzuführen.

**Claims**

1. Method for operating a magnetic resonance tomography system (1), wherein

- a first MR recording is performed so as to map an object (100) in order to generate first MR data that represents the object (100);
- the first MR recording is performed in accordance with a first k-space scanning scheme and during the first MR recording at least one first excitation pulse is transmitted in accordance with a first pulse sequence in the direction of the object (100);
- a second MR recording that is different from the first MR recording is performed in order to generate second MR data;
- a noise component is determined in dependence upon the second MR data by means of a computing unit (70) and said noise component represents an influence of at least one external noise source; and
- an MR image is generated by means of the computing unit (70) in dependence upon the first MR data and in dependence upon the noise component,
wherein the second MR recording is performed in accordance with a second k-space scanning scheme that differs from the first k-space scanning scheme,
- at least one second excitation pulse is transmitted in accordance with a second pulse sequence in the direction of the object during the second MR recording, wherein the second pulse sequence differs from the first pulse sequence; and
- the second MR data represents the object (100); and

wherein the MR image is generated in dependence upon the second MR data,
**characterised in that**

- the first pulse sequence is defined by a first time parameter set;
- the second pulse sequence is defined by a second time parameter set that differs from the first time parameter set, wherein the first time parameter set contains a first echo time and/or a first repetition time and the second pulse sequence contains a second echo time and a second repetition time, wherein the first and the second echo time and/or the first and the second repetition time differ from one another, wherein a first ratio of the first echo time to the first repetition time differs from a second ratio of the second echo time to the second repetition time, so that different contrasts are realised for the first and second MR recording in each case.

2. Method for operating a magnetic resonance tomography system (1), wherein

- a first MR recording is performed so as to map an object (100) in order to generate first MR data that represents the object (100);
- the first MR recording is performed in accordance with a first k-space scanning scheme and during the first MR recording at least one first excitation pulse is transmitted in accordance with a first pulse sequence in the direction of the object (100);
- a second MR recording that is different from the first MR recording is performed in order to generate second MR data;
- a noise component is determined in dependence upon the second MR data by means of a computing unit (70) and said noise component represents an influence of at least one external noise source; and
- an MR image is generated by means of the computing unit (70) in dependence upon the first MR data and in dependence upon the noise component,
wherein the second MR recording is performed in accordance with a second k-space scanning scheme that differs from the first k-space scanning scheme,
- at least one second excitation pulse is transmitted in accordance with a second pulse sequence in the direction of the object during the second MR recording, wherein the second pulse sequence differs in particular from the first pulse sequence; and
- the second MR data represents the object (100); and

wherein the MR image is generated in dependence upon the second MR data,
**characterised in that**

- the first k-space scanning scheme corresponds to a Cartesian scanning scheme; and
- the second k-space scanning scheme corresponds to a radial scanning scheme or a spiral scanning scheme or a wave CAIPIRINHA scanning scheme.

3. Method according to one of claims 1 or 2, wherein in dependence upon the first MR data and the second MR data a signal separation algorithm is implemented by means of the computing unit (70) in order to determine the noise component.

4. Method according to claim 3, wherein the signal separation algorithm contains an algorithm for principal component analysis or an algorithm for independent component analysis.

5. Magnetic resonance tomography system having a scanner unit (10, 20) that is configured so as to

- perform a first MR recording so as to map an object (100) in accordance with a first k-space scanning scheme in order to generate first MR data that represents the object (100), wherein during the first MR recording at least one first excitation pulse is transmitted in accordance with a first pulse sequence in the direction of the object (100); and
- perform a second MR recording that is different from the first MR recording in order to generate second MR data; and a computing unit (70) that is configured so as to
- determine in dependence upon the second MR data a noise component that represents an influence of at least one external noise source; and
- to generate an MR image in dependence upon the first MR data and the noise component,
wherein the scanner unit is configured to perform the second MR recording in accordance with a second k-space scanning scheme that differs from the first k-space scanning scheme, wherein
- the scanner unit is configured to transmit at least one second excitation pulse in accordance with a second pulse sequence in the direction of the object during the second MR recording, wherein the second pulse sequence differs from the first pulse sequence; and
- the second MR data represents the object (100) and

wherein the scanner unit is configured to generate the MR image in dependence upon the second MR data, **characterised in that**

- the first pulse sequence is defined by a first time parameter set;
- the second pulse sequence is defined by a second time parameter set that differs from the first time parameter set, wherein the first time parameter set contains a first echo time and/or a first repetition time and the second pulse sequence contains a second echo time and a second repetition time, wherein the first and the second echo time and/or the first and the second repetition time differ from one another, wherein a first ratio of the first echo time to the first repetition time differs from a second ratio of the second echo time to the second repetition time, so that different contrasts are realised for the first and second MR recording in each case.

6. Magnetic resonance tomography system having a scanner unit (10, 20) that is configured so as to

- perform a first MR recording so as to map an object (100) in accordance with a first k-space scanning scheme in order to generate first MR data that represents the object (100), wherein during the first MR recording at least one first excitation pulse is transmitted in accordance with a first pulse sequence in the direction of the object (100); and
- perform a second MR recording that is different from the first MR recording in order to generate second MR data; and a computing unit (70) that is configured so as to
- determine in dependence upon the second MR data a noise component that represents an influence of at least one external noise source; and
- to generate an MR image in dependence upon the first MR data and the noise component,
wherein the scanner unit is configured to perform the second MR recording in accordance with a second k-space scanning scheme that differs from the first k-space scanning scheme,
- the scanner unit is configured to transmit at least one second excitation pulse in accordance with a second pulse sequence in the direction of the object during the second MR recording, wherein the second pulse sequence differs in particular from the first pulse sequence; and
- the second MR data represents the object (100) and

wherein the scanner unit is configured to generate the MR image in dependence upon the second MR data, **characterised in that**

- the first k-space scanning scheme corresponds to a Cartesian scanning scheme; and
- the second k-space scanning scheme corresponds to a radial scanning scheme or a spiral scanning scheme or a wave CAIPIRINHA scanning scheme.

7. Computer program product having commands that, in the case of execution by a magnetic resonance tomography system (1) according to claim 5 or 6, prompt the magnetic resonance tomography system (1) to implement a method according to one of claims 1 to 4.

**Revendications**

1. Procédé pour faire fonctionner un système (1) de tomodensitométrie par résonance magnétique, dans lequel

- on effectue un premier enregistrement RM pour la représentation d'un objet (100), afin de produire de premières données RM, qui représentent l'objet (100) ;
- on effectue le premier enregistrement RM suivant un premier schéma de balayage dans l'espace k et, pendant le premier enregistrement RM, on envoie au moins une première impulsion d'excitation suivant une première séquence d'impulsions en direction de l'objet (100) ;

- on effectue un deuxième enregistrement RM différent du premier enregistrement RM pour produire des deuxièmes données RM ;

- en fonction des deuxièmes données RM, on détermine, au moyen d'une unité (70) informatique, une composante perturbatrice, qui représente l'influence d'au moins une source perturbatrice extérieure ; et

- au moyen de l'unité (70) informatique, on produit une image RM en fonction des premières données RM et de la composante perturbatrice,

dans lequel on effectue le deuxième enregistrement RM suivant un deuxième schéma de balayage dans l'espace k, qui est différent du premier schéma de balayage dans l'espace k,

- pendant le deuxième enregistrement RM, on envoie au moins une deuxième impulsion d'excitation suivant une deuxième séquence d'impulsions en direction de l'objet, dans lequel la deuxième séquence d'impulsions est différente de la première séquence d'impulsions ; et

- les deuxièmes données RM représentent l'objet (100), et dans lequel on produit l'image RM en fonction des deuxièmes données RM, **caractérisé en ce que**

- la première séquence d'impulsions est définie par un premier ensemble de paramètres temporels ;

- la deuxième séquence d'impulsions est définie par un deuxième ensemble de paramètres temporels, qui se distingue du premier ensemble de paramètres temporels,

dans lequel le premier ensemble de paramètres temporels contient un premier temps d'écho et/ou un premier temps de répétition et la deuxième séquence d'impulsions, un deuxième temps d'écho et un deuxième temps de répétition, dans lequel le premier et le deuxième temps d'écho et/ou le premier et le deuxième temps de répétition sont différents l'un de l'autre, dans lequel un premier rapport du premier temps d'écho au premier temps de répétition est différent d'un deuxième rapport du deuxième temps d'écho au deuxième temps de répétition, de manière à réaliser des contrastes respectivement différents pour le premier et le deuxième enregistrements RM.

2. Procédé pour faire fonctionner un système (1) de tomodensitométrie par résonance magnétique, dans lequel

- on effectue un premier enregistrement RM pour la représentation d'un objet (100), afin de produire de premières données RM, qui représentent l'objet (100) ;

- on effectue le premier enregistrement RM suivant un premier schéma de balayage dans l'espace k et, pendant le premier enregistrement RM, on envoie au moins une première impulsion d'excitation suivant une première séquence d'impulsions en direction de l'objet (100) ;

- on effectue un deuxième enregistrement RM différent du premier enregistrement RM pour produire des deuxièmes données RM ;

- en fonction des deuxièmes données RM, on détermine, au moyen d'une unité (70) informatique, une composante perturbatrice, qui représente l'influence d'au moins une source perturbatrice extérieure ; et

- au moyen de l'unité (70) informatique, on produit une image RM en fonction des premières données RM et de la composante perturbatrice,

dans lequel on effectue le deuxième enregistrement RM suivant un deuxième schéma de balayage dans l'espace k, qui est différent du premier schéma de balayage dans l'espace k, - pendant le deuxième enregistrement RM,

- on envoie au moins une deuxième impulsion d'excitation suivant une deuxième séquence d'impulsions en direction de l'objet, dans lequel la deuxième séquence d'impulsions est différente de la première séquence d'impulsions ; et

- les deuxièmes données RM représentent l'objet (100), et dans lequel on produit l'image RM en fonction des deuxièmes données RM, **caractérisé en ce que**

- le premier schéma de balayage dans l'espace k correspond à un schéma de balayage cartésien ; et

- le deuxième schéma de balayage dans l'espace k correspond à un schéma de balayage radial ou à un schéma de balayage en spirale ou à un schéma de balayage wave-CAIPIRIHNA.

3. Procédé suivant l'une des revendications 1 ou 2, dans lequel, au moyen de l'unité (70) informatique, on effectue, en fonction des premières données RM et des deuxièmes données RM, un algorithme de décomposition du signal, afin de déterminer la composante perturbatrice.

4. Procédé suivant la revendication 3, dans lequel l'algorithme de décomposition de signal contient un algorithme d'analyse de composante principale ou un algorithme d'analyse d'indépendance.

5. Système de tomodensitométrie par résonance magnétique, comportant

une unité (10, 20) de balayage, qui est agencée pour

- effectuer un premier enregistrement RM pour la représentation d'un objet (100) suivant un premier schéma de balayage dans l'espace k, afin de produire des premières données RM, qui représentent l'objet (100), dans lequel, pendant le premier enregistrement RM, une première impulsion d'excitation suivant une première séquence d'impulsions est envoyée en direction de l'objet (100) ; et
- effectuer un deuxième enregistrement RM différent du premier enregistrement RM, afin de produire des deuxièmes données RM ;

ainsi qu'une unité (70) informatique, qui est agencée pour,

- déterminer une composante perturbatrice en fonction des deuxièmes données RM, qui représente l'influence d'au moins une source perturbatrice extérieure ; et
- produire, en fonction des premières données RM et de la composante perturbatrice, une image RM,

dans lequel l'unité de balayage est agencée pour effectuer le deuxième enregistrement RM suivant un deuxième schéma de balayage dans l'espace k, qui est différent du premier schéma de balayage dans l'espace k, dans lequel

- l'unité de balayage est agencée pour envoyer, pendant le deuxième enregistrement RM, au moins une deuxième impulsion d'excitation suivant une deuxième séquence d'impulsions en direction de l'objet, dans lequel la deuxième séquence d'impulsions est différente de la première séquence d'impulsions ; et
- les deuxièmes données RM représentent l'objet (100), et dans lequel l'unité de balayage est agencée pour produire l'image RM en fonction des deuxièmes données RM,

**caractérisé en ce que**

- la première séquence d'impulsions est définie par un premier ensemble de paramètres temporels ;
- la deuxième séquence d'impulsions est définie par un deuxième ensemble de paramètres temporels, qui se distingue du premier ensemble de paramètres temporels,

dans lequel le premier ensemble de paramètres temporels contient un premier temps d'écho et/ou un premier temps de répétition et la deuxième séquence d'impulsions, un deuxième temps d'écho et un deuxième temps de répétition, dans lequel le premier et le deuxième temps d'écho et/ou le premier et le deuxième temps de répétition sont différents l'un de l'autre, dans lequel un premier rapport du premier temps d'écho au premier temps de répétition est différent d'un deuxième rapport du deuxième temps d'écho au deuxième temps de répétition, de manière à réaliser des contrastes respectivement différents pour le premier et le deuxième enregistrements RM.

6. Système de tomodensitométrie par résonance magnétique comportant

une unité (10, 20) de balayage, qui est agencée pour

- effectuer un premier enregistrement RM pour la représentation d'un objet (100) suivant un premier schéma de balayage dans l'espace k afin de produire des premières données RM, qui représentent l'objet (100), dans lequel pendant le premier enregistrement RM, on envoie au moins une première impulsion d'excitation suivant une première séquence d'impulsions en direction de l'objet (100) ; et
- effectuer un deuxième enregistrement RM différent du premier enregistrement RM afin de produire des deuxièmes données RM ;

ainsi qu'une unité (70) informatique, qui est agencée pour

- déterminer en fonction des deuxièmes données RM une composante perturbatrice, qui représente l'influence d'au moins une source perturbatrice extérieure ; et
- produire une image RM en fonction des premières données RM et de la composante perturbatrice,

dans lequel l'unité de balayage est agencée pour effectuer le deuxième enregistrement suivant un deuxième schéma de balayage dans l'espace k, qui est différent du premier schéma de balayage dans l'espace k,

- l'unité de balayage est agencée pour envoyer en direction de l'objet pendant le deuxième enregistrement RM, au moins une deuxième impulsion d'excitation suivant une deuxième séquence d'impulsions, dans lequel la deuxième séquence d'impulsions est, en particulier, différente de la première séquence d'impulsions ;

et

- les deuxièmes données RM représentent l'objet (100), et dans lequel l'unité de balayage est agencée pour produire l'image RM en fonction des deuxièmes données RM,

**caractérisé en ce que**

- le premier schéma de balayage dans l'espace k correspond à un schéma de balayage cartésien ; et
- le deuxième schéma de balayage dans l'espace k correspond à un schéma de balayage radial ou à un schéma de balayage en spirale ou à un schéma de balayage wave-CAIPIRIHNA.

7. Produit de programme d'ordinateur comprenant des instructions, qui, lors de l'exécution par un système (1) de tomodensitométrie par résonance magnétique suivant la revendication 5 ou 6, font que le système (1) de tomodensitométrie par résonance magnétique, exécute un procédé suivant l'une des revendications 1 à 4.

# FIG 1

# FIG 2

# FIG 3

FIG 4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- WO 2019068687 A2
- US 20180143272 A1
- US 20170108569 A1
- EP 3723037 A1
- EP 3470868 A1